# EUROPÄISCHE PATENTSCHRIFT

(11) **EP 0 909 121 B1**
(45) Veröffentlichungstag und Bekanntmachung des Hinweises auf die Patenterteilung: **04.12.2002**
(21) Anmeldenummer: 98117729.8
(22) Anmeldetag: 18.09.1998
(51) Int. Cl.: H05K 7/14

(54) **Elektronisches Ein-/Ausgabemodul**
Electronic I/O module
Module électronique d'entrée / sortie

(30) Priorität: 06.10.1997 DE 19743972
(43) Veröffentlichungstag der Anmeldung: 14.04.1999
(73) Patentinhaber: Phoenix Contact GmbH & Co. KG, 32825 Blomberg (DE)
(72) Erfinder: Behr, Thorsten, Dipl.-Ing., 32805 Horn - Bad Meinberg (DE); Berg, Roland, Dipl.-Ing., 37671 Höxter (DE); Brand, Jürgen, Dipl.-Ing., 32760 Detmold (DE); Fürhoff, Achim, Dipl.-Ing., 32278 Kirchlengern (DE); Grewe, Harald, Dipl.-Ing., 33175 Bad Lippspringe (DE); Hannibal, Frank, Dipl.-Ing., 32825 Blomberg (DE); Metzger, Andreas, Dipl.-Ing., 32765 Detmold (DE); Neugebauer, Werner, Dipl.-Ing., 32805 Horn - Bad Meinberg (DE); Nordhoff, Andreas, Dipl.-Ing., 32805 Horn - Bad Meinberg (DE); Oster, Viktor, Dipl.-Ing., 32825 Blomberg (DE); Pape, Andreas, Dipl.-Phys., 33034 Brakel (DE); Quardt, Dirk, Dipl.-Ing., 32816 Schieder-Schwalenberg (DE)
(74) Vertreter: Gesthuysen, von Rohr & Eggert

(56) Entgegenhaltungen:
- EP-A- 0 740 235
- DE-A- 19 512 110
- FR-A- 2 685 824

## Beschreibung

Die Erfindung betrifft ein Ein-/Ausgabemodul mit einer Anschlußeinheit zum Anschluß von Sensoren bzw. Aktoren, mit einer Elektronikeinheit und mit einem Bus-Anschlußelement, wobei die Anschlußeinheit mindestens einen in einer Ebene liegenden Ein-/Ausgang aufweist und durch die Elektronikeinheit mit dem Bus-Anschlußelement verbunden ist, vgl. EP-A-740235.

Bis vor wenigen Jahren ist die industrielle Verkabelung von Sensoren und Aktoren ausschließlich durch parallele Verkabelung eines jeden einzelnen Sensors bzw. Aktors über einzelne Leiter realisiert worden. Durch die steigende Anzahl von Sensoren und Aktoren, die heutzutage in industriellen Anlagen verwendet werden, steigt auch der Aufwand bei der Verkabelung der einzelnen Sensoren bzw. Aktoren über einzelne Leiter. Die Verkabelung erforderte immer größere und unübersichtlichere Schaltschränke, in denen alle Leiter zusammenkommen.- Aufwendige Montage- und Inbetriebnahmearbeiten bedeuten zwangsläufig hohe Personalkosten und stellen zudem ein erhöhtes Fehlerrisiko dar. Gleichzeitig steigt der Aufwand bei der Auswechslung von defekten Sensoren bzw. Aktoren oder deren Erneuerung.

Neben der Signalübertragung über parallel verlegte Leiter hat sich daher in der komplexen Automatisierungstechnik der serielle Signaltransport über Bussysteme als kostensparende Alternative zunehmend durchgesetzt. Neben den Adern für die Datenübertragung wird in solchen Bussystemen auch die Versorgung für die angeschlossenen Sensoren bzw. Aktoren mitgeführt. Platzraubende, unübersichtliche und damit aufwendig zu verdrahtende Schaltschränke entfallen und werden durch kleinere und dezentrale Ein-/Ausgabemodule ersetzt.

Durch den seriellen Signaltransport über Bussysteme wird zwar eine übersichtlichere Verbindung der einzelnen Sensoren und Aktoren untereinander und mit der Steuerung erreicht, auch wird der Aufwand bei Montage und Inbetriebnahme verringert, die Auswechslung detekter Ein-/Ausgabemodule oder deren Erneuerung ist jedoch immer noch relativ aufwendig, damit zeitraubend und kostenintensiv. Darüber hinaus sieht sich der Anwender immer häufiger dazu gezwungen, bestehende Anlagen zu verändern und Teile der Verbindungstechnik auszutauschen, um diese an neue Bedingungen anzupassen.

Der vorliegenden Erfindung liegt somit die Aufgabe zugrunde, das eingangs genannte Ein-/Ausgabemodul dahingehend zu verbessern, daß Montage- und Inbetriebnahmearbeiten einfach durchzuführen sind und die Elektronik des Ein-/Ausgabemoduls leicht zu verändern ist, so daß das Ein-/Ausgabemodul veränderten Anforderungen einfach anzupassen ist.

Die zuvor aufgezeigte Aufgabe ist erfindungsgemäß dadurch gelöst, daß zum Austauschen der Elektronikeinheit die Anschlußeinheit von der Elektronikeinheit abnehmbar ist, ohne an den Ein-/Ausgängen angeschlossene Leitungen entfernen zu müssen. Durch diese Art der Modultechnik kann eine Anpassung des Ein-/Ausgabemoduls an veränderte Anforderungen und eine Reparatur der Elektronikeinheit durch Austauschen derselben bei stehender Verdrahtung erfolgen.

Besonders vorteilhafterweise ist das Ein-/Ausgabemodul so ausgestaltet, daß die Anschlußeinheit in zwei verschiedenen Positionen mit der Elektronikeinheit verbunden werden kann, so daß die Ein-/Ausgänge der Anschlußeinheit bei den beiden Positionen in zueinander um etwa 90° versetzten Ebenen liegen. Hierdurch wird eine größere Flexibilität bei der Verlegung der Leitungen für die Sensoren bzw. Aktoren erreicht. Wird das Ein-/Ausgabemodul beispielsweise an einer Wand befestigt, so können die Leitungen der Sensoren bzw. Aktoren sowohl von vorne als auch von oben bzw. sowohl von vorne als auch von unten an das Ein-/Ausgabemodul herangeführt werden. Vorteilhafterweise ist das zuvor beschriebene Ein-/Ausgabemodul dadurch weiter verbessert, daß die Elektronikeinheit die beiden unterschiedlichen Positionen, in denen die Anschlußeinheit mit der Elektronikeinheit verbunden ist, diagnostiziert und die Auswertung entsprechend anpaßt. Hierdurch ist bei einem Umstecken der Anschlußeinheit-kein nachträgliches manuelles Anpassen der Elektronik erforderlich, so daß der Vorteil der Flexibilität der Anschlußrichtungen der Leitungen durch die Möglichkeit des Umsteckens nicht durch einen höheren Aufwand beim Anpassen der Elektronik erkauft wird.

Als Bus-Leitung, an die das Bus-Anschlußelement angeschlossen wird, kann sowohl ein Lichtwellenleiter als auch ein herkömmliches Kupferkabel als auch jedes andere elektrische Kabel verwendet werden. Wird als Bus-Leitung ein Lichtwellenleiterkabel verwendet, so weist das Bus-Anschlußelement vorteilhafterweise einen Halteblock auf, in den das Lichtwellenleiterkabel eingeschoben werden kann. Nach einer weiteren Lehre der Erfindung befindet sich dann in dem Bus-Anschlußelement mindestens ein Optokoppelelement, mit dessen Kontaktstirnfläche das Lichtwellenleiterkabel durch Einschieben des Halteblocks in das Bus-Anschlußelement zusammenwirkt.

Besonders einfach ist das Anschließen eines Lichtwellenleiterkabels an das erfindungsgemäße Ein-/Ausgabemodul dann, wenn nach einer weiteren Lehre der Erfindung das Bus-Anschlußelement eine Schneide aufweist und die Schneide beim Einschieben des das Lichtwellenleiterkabel führenden Halteblocks in das Bus-Anschlußelement die Enden des Lichtwellenleiterkabels abtrennt.

Wird als Bus-Leitung eine elektrische Leitung, beispielsweise ein Kupferkabel verwendet, so weist das Bus-Anschlußelement des erfindungsgemäßen Ein-/Ausgabemoduls vorteilhafterweise eine Öffnung zur Aufnahme mindestens einer elektrischen Leitung auf und sind dabei im Inneren des Bus-Anschlußelements Kontaktierschwerter angebracht, die die elektrische Leitung durchdringen.

Im einzelnen gibt es nun eine Vielzahl von Möglichkeiten, das erfindungsgemäße Ein-/Ausgabemodul auszugestalten. Dazu wird verwiesen einerseits auf die dem Patentanspruch 1 nachgeordneten Patentansprüche, andererseits auf die Beschreibung bevorzugter Ausführungsbeispiele in Verbindung mit der Zeichnung. In der Zeichnung zeigen
- Fig. 1: ein Ein-/Ausgabemodul mit einer angeschlossenen Bus-Leitung,
- Fig. 2a: eine Ausführungsform eines Bus-Anschlußelements eines Ein-/Ausgabemoduls, bei dem Lichtwellenleiter als Bus-Leitungen verwendet werden, im vormontierten Zustand,
- Fig. 2b: das Bus-Anschlußelement aus Fig. 2a, nachdem die Lichtwellenleiterkabel angeschlossen sind,
- Fig. 3: Teile des Gehäuses eines Ein-/Ausgabemoduls, bei dem elektrische Leitungen als Bus-Leitung verwendet werden,
- Fig. 4: eine weitere Ausführungsform eines Bus-Anschlußelements und
- Fig. 5: eine zu der Ausführungsform nach den Fig. 2a bzw. 2b alternative Ausführungsform eines Bus-Anschlußelements für ein Ein-/Ausgabemodul, bei dem Lichtwellenleiterkabel als Bus-Leitungen verwendet werden.

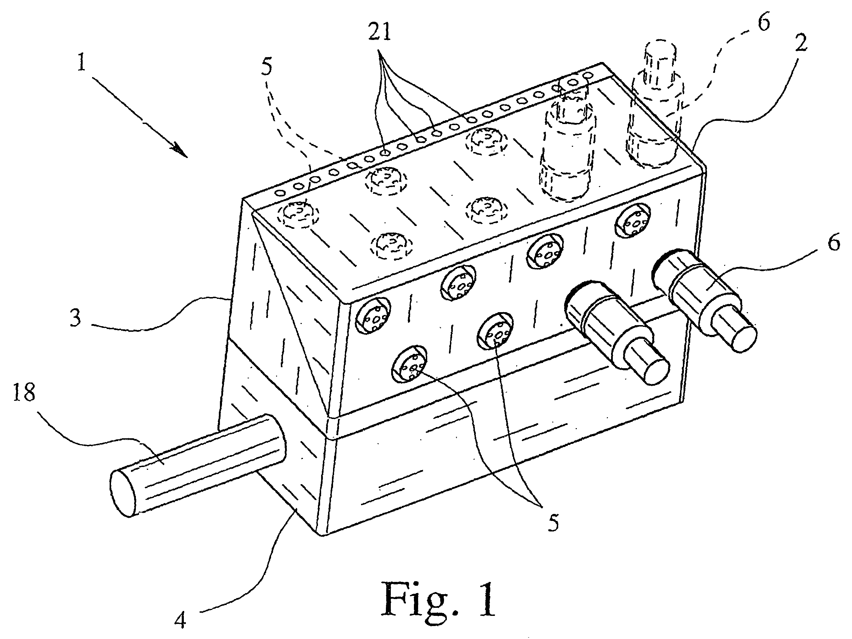

Fig. 1 zeigt ein Ein-/Ausgabemodul 1, das aus einer Anschlußeinheit 2, einer Elektronikeinheit 3 und einem Bus-Anschlußelement 4 besteht. Das Ein-/Ausgabemodul 1 ist insgesamt rechteckig, wobei das Bus-Anschlußelement 4 ebenfalls rechteckig ist und die Anschlußeinheit 2 und die Elektronikeinheit 3 jeweils dreieckig sind. Die Anschlußeinheit 2 und die Elektronikeinheit 3 werden so miteinander verbunden, daß sie zusammen einen rechteckförmigen Körper bilden. An einer der beiden von außen zugänglichen Flächen der Anschlußeinheit 2 befinden sich Ein-/Ausgänge 5. An diese Ausgänge 5 werden Leitungen 6 von hier nicht dargestellten Sensoren bzw. Aktoren angeschlossen.

Die Anschlußeinheit 2 ist nun so ausgeführt, daß sie auch derart auf die Elektronikeinheit 3 aufsteckbar ist, daß die Ein-/Ausgänge 5 in einer um etwa 90° vesetzten Ebene liegen. Bei dem Ein-/Ausgabemodul 1, wie es in Fig. 1 dargestellt ist, bedeutet dies, daß die Ein-/Ausgänge 5 nicht nur - wie hier durchgezogen dargestellt - nach vorne zeigen können, sondern dann, wenn die Anschlußeinheit 2 gemäß der zweiten Möglichkeit auf der Elektronikeinheit 3 aufgesteckt ist, die Ein-/Ausgänge 5 auch - wie hier gestrichelt dargestellt - nach oben zeigen können. Somit können hier die Leitungen 6 durch einfaches Umstecken der Anschlußeinheit 2 sowohl von vorne als auch von oben an die Ein-/Ausgänge 5 angeschlossen werden.

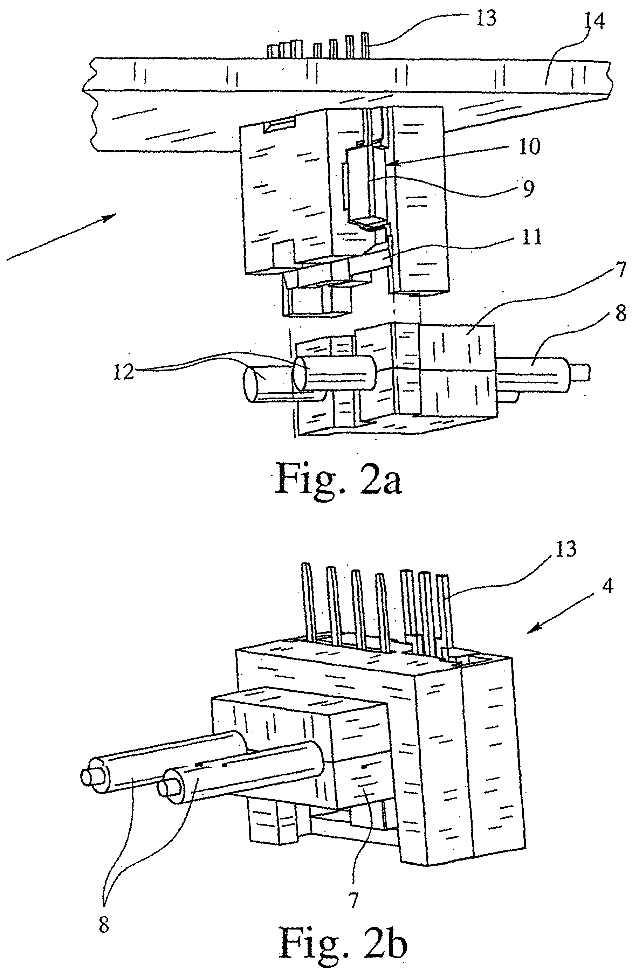

Die Fig. 2a bzw. 2b zeigen nun ein Bus-Anschlußelement 4, bei dem in einem Halteblock 7 Lichtwellenleiterkabel 8 eingeführt sind. Der Halteblock 7 dient dabei nicht nur zur Aufnahme der Lichtwellenleiterkabel 8, sondern gleichzeitig auch als Zugentlastung für die Lichtwellenleiterkabel 8. Das Bus-Anschlußelement 4 enthält ein Optokoppelelement 9, mit dessen Kontaktstirnflächen 10 die Lichtwellenleiterkabel 8 zur Übertragung von Signalen zusammenwirken. In Fig. 2a, die den vormontierten Zustand darstellt, ist eine Schneide 11 sichtbar, die in einer Ebene mit den Kontaktstirnfflächen 10 des Optokoppelelements 9 liegt. Wird das Halteelement 7 mit den. Lichtwellenleiterkabeln 8 in das Bus-Anschlußelement 4 eingeschoben, so werden die Enden 12 der Lichtwellenleiterkabel 8 durch die Schneide 11 abgetrennt. Dadurch wird eine exakte Positionierung der Stirnfläche des Lichtwellenleiterkabels 8 vor der Kontaktstirnfläche 10 des Optokoppelelements 9 erreicht. Über elektrische Anschlüsse 13 wird das Optokoppelelement 9 mit der hier nicht dargestellten Elektronikeinheit 3 verbunden. Die Elektronikeinheit 3 befindet sich im zusammengesetzten Zustand des Ein-/Ausgabemoduls 1 auf einer Leiterplatte 14, die den oberen Abschluß des Bus-Anschlußelements 4 bildet.

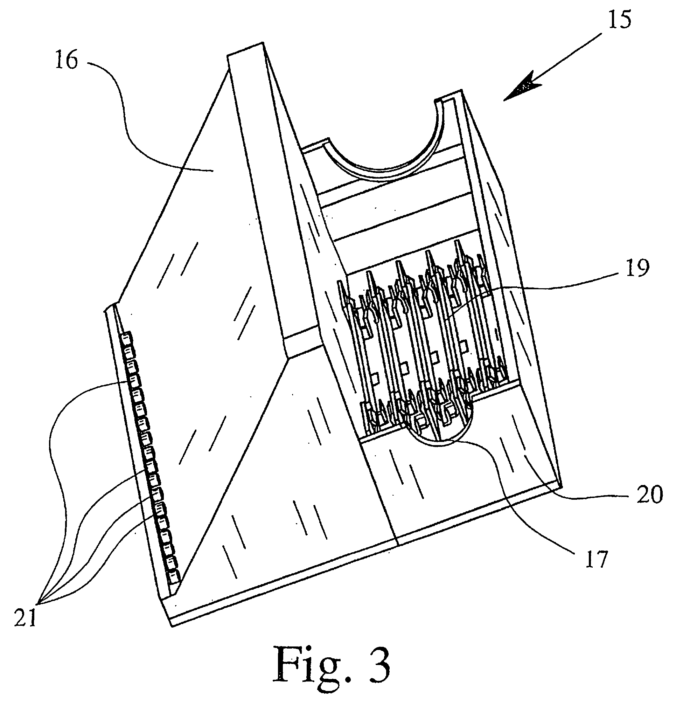

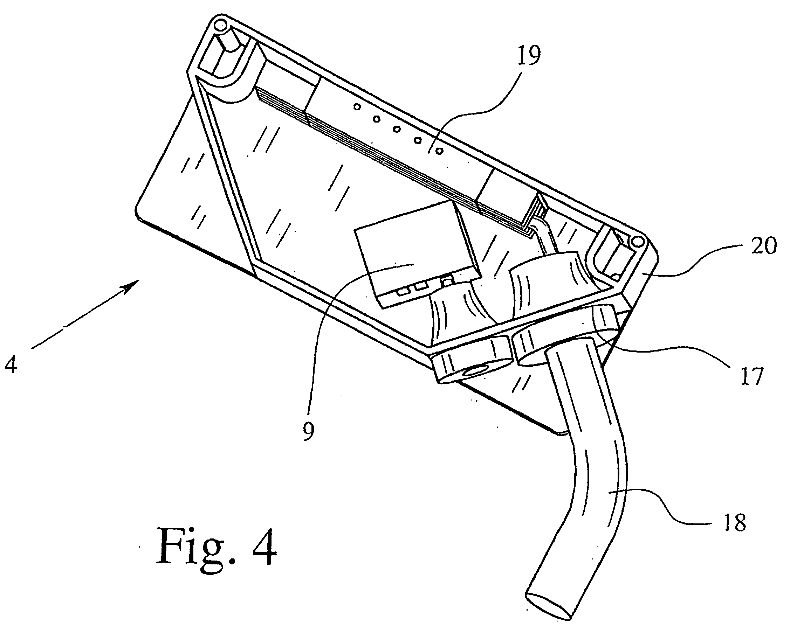

Fig. 3 zeigt einen Teil des Gehäuses des Ein-/Ausgabemoduls 1, nämlich die eine Hälfte 15 des Bus-Anschlußelements 4 und das Gehäuse 16 der Elektronikeinheit 3. Das Bus-Anschlußelement 4, von dem hier nur eine Hälfte 15 dargestellt ist, weist eine Öffnung 17 zur Aufnahme einer elektrischen Leitung 18 auf. Im Inneren des Bus-Anschlußelements 4 sind Kontaktierschwerter 19 angeordnet, die für den elektrischen Kontakt zwischen dem Ein-/Ausgabemodul 1 und der elektrischen Leitung 18 sorgen. Solche Kontaktierschwerter 19 haben den Vorteil, daß eine elektrische Leitung 18, wie sie in den Fig. 1 und 4 dargestellt ist, also lediglich in die.Öffnung 17 des Bus-Anschlußelements 4 eingeschoben zu werden brauchen. Die Kontaktierschwerter 19 durchdringen die Ummantelung der elektrischen Leitung 18 und dringen in das Kupferkabel ein. Somit ist kein Verschrauben oder Verklemmen der elektrischen Leitung 18 notwendig.

In Fig. 3 befindet sich die Öffnung 17 an einer der beiden kürzeren Außenflächen 20 des Bus-Anschlußelements 4. Bei dem Bus-Anschlußelement 4, wie es in Fig. 4 dargestellt ist, befindet sich die Öffnung 17 in einer Ebene, die um 45° zur Außenfläche 20 versetzt ist. Dadurch ist ein einfaches Anschließen der elektrischen Leitung 18 unabhängig davon möglich, ob sie parallel oder senkrecht zur Längsrichtung des Bus-Anschlußelements 4 auf dieses zugeführt wird.

An einer Längsseite der Elektronikeinheit 3 befinden sich, wie in den Fig. 1 und 3 dargestellt, mehrere Leuchtdioden 21, die zur visuellen Überprüfung aller Ein-/Ausgänge 5 der Anschlußeinheit 2 dienen. Sind alle Ein-/Ausgänge 5 unabhängig voneinander gegen Kurzschluß geschützt, so kann ein Kurzschluß eines Ein-/Ausganges 5 durch einen Farbwechsel der entsprechenden Leuchtdiode 21 am Ein-/Ausgabemodul 1 angezeigt werden. Durch eine entsprechende Verschaltung der Elektronikeinheit 3 bleibt die räumliche Zuordnung zwischen den einzelnen Ein-/Ausgängen 5 und den dazu korrespondierenden Leuchtdioden 21 auch beim Umstecken der Anschlußeinheit 2 erhalten.

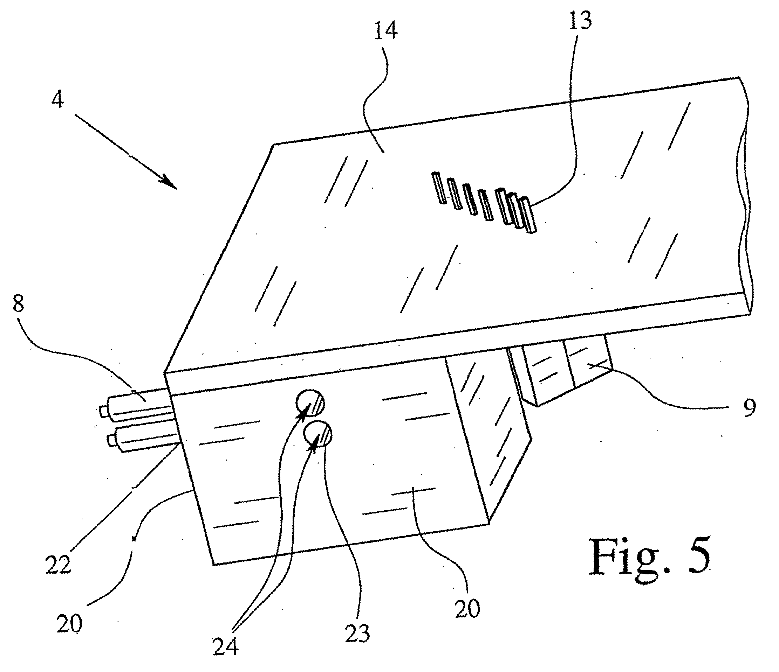

Fig. 5 zeigt ein Bus-Anschlußelement 4 mit einem Optokoppelelement 9, bei dem die Lichtwellenleiterkabel 8 in unterschiedliche Öffnungen 22, 23 eingeführt werden können und die Öffnungen 22, 23 sich in zueinander senkrechten Außenflächen 20 befinden. Auch hierbei ist wieder die Möglichkeit eines einfachen Anschlusses des Lichtwellenleiterkabels 8 an das Ein-/Ausgabemodul 1 gegeben, auch wenn das Lichtwellenleiterkabel 8 aus zwei zueinander senkrechten Richtungen auf das Ein-/Ausgabemodul 1 geführt wird. Da aber bei dem Ausführungsbeispiel des Bus-Anschlußelements 4, wie es in Fig. 5 dargestellt ist, im Unterschied zu dem Ausführungsbeispiel des Bus-Anschlußelements 4, wie es in den Fig. 2a bzw. 2b dargestellt ist, keine Schneide 11 vorhanden ist, muß hier vor dem Einführen des Lichtwellenleiterkabels 8 in die Öffnungen 22 bzw. 23 die Stirnfläche des Lichtwellenleiterkabels 8'vorbehandelt sein. Die Führung des Lichtwellenleiterkabels 8 zum Optokoppelelement 9 erfolgt über Kanäle 24 im Inneren des Bus-Anschlußelements 4.

Anstelle eines Lichtwellenleiterkabels 8 können auch elektrische Leitungen-18 durch die Öffnungen 22 bzw. 23 und einen Kanal 24 zu einer Anschlußstelle des Bus-Anschlußelements 4 geführt werden. Dann befinden sich an der Stelle des in Fig. 5 dargestellten Optokoppelelements 9 die aus Fig. 3 und Fig. 4 bekannten Kontaktierschwerter 19.

## Patentansprüche

1. Ein-/Ausgabemodul mit einer Anschlußeinheit (2) zum Anschluß von Sensoren bzw. Aktoren, mit einer Elektronikeinheit (3) und mit einem Bus-Anschlußelement (4), wobei die Anschlußeinheit (2) mindestens einen in einer Ebene liegenden Ein-/Ausgang (5) aufweist und durch die Elektronikeinheit (3) mit dem Bus-Anschlußelement (4) verbunden ist, **dadurch gekennzeichnet, daß** die Anschlußeinheit (2) auf die Elektronikeinheit (3) aufgesteckt ist und zum Austauschen der Elektronikeinheit (3) die Anschlußeinheit (2) von der Elektronikeinheit (3) bei stehender Verdrahtung abnehmbar ist, d. h. ohne das die an den Ein-/Ausgängen (5) angeschlossenen Leitungen (6) entfernt werden müssen.

2. Ein-/Ausgabemodul nach Anspruch 1, **dadurch gekennzeichnet, daß** die Anschlußeinheit (2) in zwei verschiedenen Positionen mit der Elektronikeinheit (3) verbunden werden kann, sodaß die Ein-/Ausgänge (5) der Anschlußeinheit (2) bei den beiden Positionen. in zueinander um etwa 90° versetzten Ebenen liegen.

3. Ein -/Ausgabemodul nach Anspruch 2, **dadurch gekennzeichnet, daß** die Elektronikeinheit (3) die beiden unterschiedlichen Positionen, in denen die Anschlußeinheit (2) mit der Elektronikeinheit (3) verbunden ist, diagnostiziert und die Auswertung entsprechend anpaßt.

4. Ein-/Ausgabemodul nach einem der Ansprüche 1 bis 3, **dadurch gekennzeichnet, daß** das Ein-/Ausgabemodul (1) insgesamt und das Bus-Anschlußelement (4) im wesentlichen rechteckig sowie die Anschlußeinheit (2) und die Elektronikeinheit (3) jeweils etwa dreieckförmig sind und die Elektronikeinheit (3) und die Anschlußeinheit (2) zusammen etwa rechteckförmig sind.

5. Ein -/ Ausgabemodul nach einem der Ansprüche 1 bis 4, **dadurch gekennzeichnet, daß** das Bus-Anschlußelement (4) einen Halteblock (7) aufweist und in den Halteblock (7) mindestens ein Lichtwellenleiterkabel (8) als Bus-Leitung einschiebbar ist

6. Ein-/Ausgabemodul nach Anspruch 5, **dadurch gekennzeichnet, daß** das Bus-Anschlußelement (4) mindestens ein Optokoppelelement (9) aufweist und das Lichtwellenleiterkabel (8) durch Einschieben des Halteblocks (7) in das Bus-Anschlußelement (4) mit der Kontaktstirnfläche (10) des Optokoppelements (9) zusammenwirkt.

7. Ein-/Ausgabemodul nach Anspruch 6, **dadurch gekennzeichnet, daß** das Bus-Anschlußelement (4) eine Schneide (11) aufweist und die Schneide (11) beim Einschieben des das Lichtwellenleiterkabel (8) führenden Halteblocks (7) in das Bus-Anschlußelement (4) die Enden (12) des Lichtwellenleiterkabels (8) abtrennt.

8. Ein-/Ausgabemodul nach einem der Ansprüche 1 bis 4, **dadurch gekennzeichnet, daß** das Bus-Anschlußelement (4) eine Öffnung (17) zur Aufnahme mindestens einer elektrischen Leitung (18) aufweist und im Inneren des Bus-Anschlußelements (4) Kontaktierschwerter (19) angebracht sind, die die elektrischen Leitungen (18) durchdringen.

9. Ein-/Ausgabemodul nach Anspruch 8, **dadurch gekennzeichnet, daß** die Öffnung (17) des Bus-Anschlußelements (4) in einer Ebene liegt, die um 45° versetzt zu den Außenflächen (20) des Bus-Anschlußelements (4) ist.

10. Ein-/Ausgabemodul nach einem der Ansprüche 1 bis 9, **dadurch gekennzeichnet, daß** die Elektronikeinheit Leuchtdioden (21) zur visuellen Überprüfung aller Ein-/Ausgänge (5) der Anschlußeinheit (2) aufweist.

11. Ein-/Ausgabemodul nach einem der Ansprüche 1 bis 4, **dadurch gekennzeichnet, daß** das Bus-Anschlußelement (4) zur Aufnahme mindestens einer Bus-Leitung Öffnungen (22, 23) an zwei zueinander senkrecht stehenden Außenflächen (20) aufweist und die Führung der Bus-Leitung zur Anschlußstelle im Inneren des Bus-Anschlußelements (4) durch Kanäle (24) im Inneren des Bus-Anschlußelements (4) erfolgt.

## Claims

1. Input/output module with a terminal unit (2) for connection of sensors or actuators, comprising an electronic unit (3) and a bus connection element (4), wherein the terminal unit (2) is connected by the electronic unit (3) to the bus connection element (4), **characterized in that**, in order to replace the electronic unit (3), the terminal unit (2) is mounted on the electronic unit (3) with fixed wiring, i.e. without the need to remove lines (6) connected to the inputs/outputs (5) of the terminal unit (2).

2. Input/output module according to claim 1, **characterized in that** the terminal unit (2) is connectable to the electronic unit (3) in two different positions, so that the input/output (5) of the terminal unit (2) lies in a respective plane in each of the two positions, said planes being offset by roughly 90 degrees relative to one another.

3. Input/output module according to claim 2, **characterized in that** the electronic unit (3) has means for recognizing in which of the two different positions the terminal unit (2) is connected to the electronic unit (3) and adapting itself accordingly.

4. Input/output module according to any one of claims 1 to 3, **characterized in that** the input/output modules (1) as a whole and the bus connection unit (4) by itself are essentially rectangular, that the terminal unit (2) and the electronic unit (3) are each roughly triangular, and that the electronic unit (3) and the terminal unit (2) together are roughly rectangular.

5. Input/output module according to any one of claims 1 to 4, **characterized in that** the bus connection element (4) has a holding block (7) and at least one fiber optic cable (8), as a bus line, which is insertable in the holding block (7).

6. Input/output module according to claim 5, **characterized in that** the bus connection element (4) has at least one optical coupling element (9) and the fiber optic cable (8) interacts with a contact face (10) of the optical coupling element (9) upon insertion of the holding block (7) into the bus connection element (4).

7. Input/output module according to claim 6, **characterizing in that** the bus connection element (4) has a cutting edge (11) and the cutting edge (11) separates the ends of the fiber optic cable (8) when the holding block (7) with the fiber optic cable (8) therein is pushed into the bus connection element (4).

8. Input/output module according to any one of claims 1 to 4, **characterized in that** the bus connection element (4) has an opening (17) for holding at least one electrical line (18) and, within the bus connection element (14), contact tongues (19) are attached for penetrating the electrical line (18).

9. Input/output module according to claim 8, **characterized in that** the opening (17) of the bus connection element (4) lies in a plane which is offset by 45° relative to an outer surface (20) of the bus connection element (4).

10. Input/output module according to any one of claims 1 to 9, **characterized in that** the electronic unit has light-emitting diodes (21) for visually examining all inputs/outputs (5) of the terminal unit (2).

11. Input/output module according to any one of claims 1 to 4, **characterized in that** the bus connection element (4) has openings (22, 23) for holding at least one bus line on two outer surfaces (20) thereof which are perpendicular to one another, and that channels (24) are provided within the bus connection element (4) for guiding the bus line to a terminal site within the bus connection element (4).

## Revendications

1. Module d'entrée/sortie avec une unité de raccordement (2) pour le raccordement de capteurs et d'actionneurs, avec une unité d'électronique (3) et avec un élément de raccordement de bus (4), l'unité de raccordement (2) présentant au moins une entrée/sortie (5) disposée dans un plan et étant reliée par l'unité d'électronique (3) à l'élément de raccordement de bus (4), **caractérisé en ce que** l'unité de raccordement (2) est emboîtée sur l'unité d'électronique (3) et peut être enlevée de l'unité d'électronique (3) dans le cas d'un câblage vertical pour le remplacement de l'unité d'électronique (3), c'est-à-dire sans qu'on soit obligé d'enlever les lignes (6) raccordées aux entrées/sorties (5).

2. Module d'entrée/sortie selon la revendication 1, **caractérisé en ce que** l'unité de raccordement (2) peut être reliée dans deux positions différentes à l'unité d'électronique (3), de sorte que les entrées/sorties (5) de l'unité de raccordement (2) sont disposées pour les deux positions dans les plans décalés d'environ 90° l'un par rapport à l'autre.

3. Module d'entrée/sortie selon la revendication 2, **caractérisé en ce que** l'unité d'électronique (3) diagnostique les deux positions différentes, dans lesquelles l'unité de raccordement (2) est reliée à l'unité d'électronique (3), et adapte l'analyse en conséquence.

4. Module d'entrée/sortie selon l'une quelconque des revendications 1 à 3, **caractérisé en ce que** le module d'entrée/sortie (1) et l'élément de raccordement au bus (4) sont respectivement globalement et essentiellement rectangulaires, l'unité de raccordement (2) et l'unité d'électronique (3) sont chacun à peu près de forme triangulaire et l'unité d'électronique (3) et l'unité de raccordement (2) ont ensemble une forme à peu près rectangulaire.

5. Module d'entrée/sortie selon l'une quelconque des revendications 1 à 4, **caractérisé en ce que** l'élément de raccordement au bus (4) présente un bloc de support (7) et au moins un câble à fibres optiques (8) peut être introduit comme ligne de bus dans le bloc de support (7).

6. Module d'entrée/sortie selon la revendication 5, **caractérisé en ce que** l'élément de raccordement au bus (4) présente au moins un élément de couplage optique (9) et le câble à fibres optiques (8) agit conjointement avec la surface frontale de contact (10) de l'élément de couplage optique (9) par l'introduction du bloc de support (7) dans l'élément de raccordement au bus (4).

7. Module d'entrée/sortie selon la revendication 6, **caractérisé en ce que** l'élément de raccordement au bus (4) présente une lame (11) et la lame (11) sépare les extrémités (12) du câble à fibres optiques (8) lors de l'introduction du bloc de support (7), guidant le câble à fibres optiques (8), dans l'élément de raccordement au bus (4).

8. Module d'entrée/sortie selon l'une quelconque des revendications 1 à 4, **caractérisé en ce que** l'élément de raccordement au bus (4) présente une ouverture (17) pour le logement d'au moins une ligne électrique (18) et à l'intérieur de l'élément de raccordement au bus (4) sont disposées des lames de contact (19), qui traversent les lignes décrites (18).

9. Module d'entrée/sortie selon la revendication 8, **caractérisé en ce que** l'ouverture (17) de l'élément de raccordement au bus (4) est située dans un plan qui est décalé de 45 % par rapport aux surfaces extérieures (20) de l'élément de raccordement au bus (4) .

10. Module d'entrée/sortie selon l'une quelconque des revendications 1 à 9, **caractérisé en ce que** l'unité d'électronique présente des diodes électroluminescentes (21) pour le contrôle visuel de toutes les entrées/sorties (5) de l'unité de raccordement (2).

11. Module d'entrée/sortie selon l'une quelconque des revendications 1 à 4, **caractérisé en ce que** l'élément de raccordement au bus (4) présente pour le logement d'au moins une ligne de bus des ouvertures (22, 23) sur deux surfaces extérieures (20) perpendiculaires entre elles et le guidage de la ligne de bus vers le point de raccordement s'effectue à l'intérieur de l'élément de raccordement au bus (4) par des canaux (24) situés à l'intérieur de l'élément de raccordement au bus (4).
